# EUROPEAN PATENT APPLICATION

(11) **EP 3 182 463 A1**
(43) Date of publication of application: **21.06.2017**
(21) Application number: 15200785.2
(22) Date of filing: 17.12.2015
(51) Int. Cl.: H01L 29/808, H01L 29/06, H01L 29/78, H01L 29/20, H01L 29/16

(54) **REVERSE BLOCKING POWER SEMICONDUCTOR DEVICE**

(71) Applicant: ABB Technology AG, 8050 Zürich (CH)
(72) Inventor: Friedhelm, Bauer, 6714 Semione (CH)
(74) Representative: ABB Patent Attorneys

(57) **Abstract**

A reverse blocking power semiconductor device is provided, wherein in an active area (10), which is laterally surrounded by a termination area (12), following layers are arranged between a first main side (20) and a second main side (30) opposite to the first main side (20): an n doped source layer (4), a p doped channel layer (5) and an n- doped drift layer (6).

The source layer (4) is contacted by a first main electrode (2), which forms an ohmic contact (22) at least to the source layer (4). The drift layer (6) is contacted by a second main electrode (3), which forms a Schottky contact (32) to the drift layer (6).

In the termination area (12) on the first main side (20) a p doped junction termination layer (8) is arranged. On lateral sides (15) of the semiconductor device a bridging layer (9) is arranged, by which the junction termination layer (8) is connected to a potential of the second main electrode (3).

## Description

### Technical Field

The invention relates to the field of power electronics and more particularly to a reverse blocking power semiconductor device according to the preamble of claim 1.

### Background Art

A prior art vertical reverse-blocking insulated gate bipolar transistor (RB-IGBT) has bipolar current conduction mode in the on-state (forward direction), forward blocking capability and reverse blocking capability. It has gained importance in the construction of fully bi-directional (conduction and blocking) power semiconductor switches required in diverse power electronic applications.

In an active area, which is laterally surrounded by a termination area, the following layers are arranged between a first main side and a second main side opposite to the first main side: an n doped source layer, a p doped channel layer, an n- doped drift layer and a p doped anode layer. In the termination area on the first main side a p doped junction termination layer is arranged. The RB-IGBT features p-doped isolation regions along lateral edges of the device in order to connect the p-doped anode layer with the voltage termination on the top (cathode) side of the device. This is typically achieved using deep (cathode to anode) p-type diffusions. For this reason, the RB-IGBT concept is restricted in silicon to voltage classes up to 1.2 kV.

An anti-parallel connection of two bi-directionally blocking power semiconductor switches like RB-IGBTs provides full bi-directionality. In such an arrangement, forward and reverse conduction is handled by two different devices: both devices of the bi-directional switch provide conduction using the bipolar conduction mode.

A power semiconductor switch able of conducting and blocking current in two directions is desirable in several power electronic applications. Embedding a uni-directional switch in a diode bridge arrangement achieves full bi-directionality, however, at the cost of a high count of discrete devices (either two if RC-IGBTs are used, which have implemented a free wheeling diode on a common substrate with the IGBT by integrating n doped regions on the anode side or four if discrete IGBT and diode devices are used) and accordingly high losses.

### Disclosure of Invention

It is an object of the invention to provide semiconductor device providing a unipolar current conduction mode in the on-state (forward direction), forward blocking capability and reverse blocking capability.
This object is achieved by a reverse blocking power semiconductor device according to the invention.

An inventive reverse blocking power semiconductor device comprises an active area, which is laterally surrounded by a termination area. Following layers are arranged between a first main side and a second main side opposite to the first main side:
- a source layer of a first conductivity type,
- a channel layer of a second conductivity type, which is different from the first conductivity type,
- a drift layer of the first conductivity type.

In the termination area on the first main side a junction termination layer of the second conductivity type is arranged. On the first main side, at least the source layer is contacted by a first main electrode, which forms an ohmic contact at least to the source layer.

On the second main side, the drift layer is contacted by a second main electrode, which forms a Schottky contact to the drift layer. On lateral sides of the semiconductor device a bridging layer is arranged, by which the junction termination layer is connected to a potential of the second main electrode.

The inventive device is a vertical device, in which the first main electrode is arranged on the first main side and a second main electrode is arranged on the second main side opposite to the first main side.
The inventive semiconductor device is a unipolar device, which may be made of wide bandgap material, exemplarily of silicon carbide or of Gallium nitride or of Aluminium nitride. The drain electrode (second main electrode) is implemented as a Schottky contact. The Schottky drain contact will conduct when a positive voltage is applied to the drain (forward mode). However, it will block when the polarity at the drain is reversed (reverse blocking).

In the inventive device, on the substrate edges, a bridging layer is arranged, exemplarily as p-doped layer. Alternatively, the drain Schottky contact may be extended along the chip edges to reach the first main surface close to the junction termination layer or contacting the junction termination layer. By the integration of the bridging layer in combination with the Schottky contact as second main electrode (drain electrode) a reverse blocking functionality is implementable into unipolar switches, a functionality, which has not been available for prior art unipolar devices (having an n doped drain layer).

The second main electrode having a Schottky contact provides blocking capability when the correct polarity is chosen. The unipolar switch will enter the reverse blocking mode when the electrical potential at the source is higher than the potential at the drain. In the inverse case, the switch operates in the forward direction (electrical potential at the source is lower than the potential at the drain). Forward conduction or forward blocking depends on the respective gate voltage (above or below the threshold voltage).

The Schottky drain contact as second main electrode may be integrated into unipolar devices as for example planar or trench power MOSFET, planar or trench JFET and superjunction structures of such power MOSFETs or JFETs.

The second main electrode formed as a Schottky contact has an increased on-state (forward) voltage drop caused by the Schottky barrier. For very high voltages, exemplarily SiC is used as semiconductor material. Contrary to prior art SiC-IGBTs, for the inventive device the voltage limit can be raised to 10 keV or even higher. At such voltage classes, the additional Schottky barrier voltage drop has only small influence.

However, as is the case with prior art RB-IGBTs, on-state losses will outperform the back-to-back arrangement of uni-directional switches thanks to the fact that RB-type switches utilize the same drift layer for forward and reverse blocking. For this reason, the Schottky drain concept is also applicable for SiC MOSFET, SiC JFET and for LV solid-state circuit breaker applications.

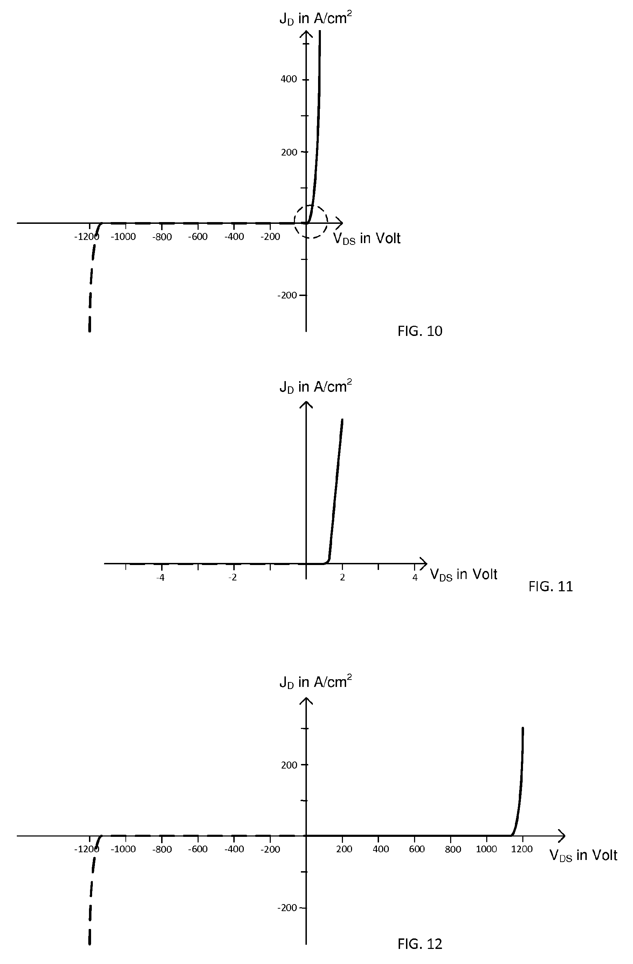

FIG 10 to 12 show the ability of an inventive SiC MOSFET to block both forward and reverse voltages. In FIG 10, the straight line shows forward conduction and the dotted line reverse blocking characteristics at 400 K. FIG 11 gives a detailed view on the transition from negative to positive drain-to-source voltages. The additional Schottky barrier drop is apparent in the on-state characteristics shown in Fig 11. The device on-state and blocking is fully controlled by the MOS gate voltage. FIG 12 shows forward blocking (straight line) and reverse blocking characteristics (dotted line) at 400 K.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows an inventive MOSFET with a planar gate electrode, field rings as termination layer and a lateral termination Schottky contact;
- FIG 2: shows an inventive MOSFET with a planar gate electrode, field rings as termination layer and a lateral termination layer;
- FIG 3: shows an inventive MOSFET with a trench gate electrode, field rings as termination layer and a lateral termination Schottky contact;
- FIG 4: shows an inventive MOSFET with a planar gate electrode, field rings as termination layer and a lateral termination Schottky contact at an angle α;
- FIG 5: shows an inventive MOSFET with a planar gate electrode, a VLD layer as termination layer and a lateral termination Schottky contact;
- FIG 6: shows an inventive MOSFET with a planar gate electrode, a JTE layer as termination layer and a lateral termination Schottky contact;
- FIG 7: shows an inventive MOSFET with a planar gate electrode, a JTE layer as termination layer, a lateral termination Schottky contact and alternating n and p doped layers on the second main side;
- FIG 8: shows an inventive JFET with field rings as termination layer and a lateral termination Schottky contact;
- FIG 9: shows an inventive JFET with field rings as termination layer and a lateral termination Schottky contact;
- FIG 10: shows forward conduction and reverse blocking characteristics for an inventive MOSFET;
- FIG 11: shows a detail of FIG 10 (voltages around 0V); and
- FIG 12: shows forward blocking and reverse conduction characteristics for an inventive MOSFET.
The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

An inventive reverse blocking unipolar power semiconductor device comprises in an active area 10, which is laterally surrounded by a termination area 12, layers between a first main side 20 and a second main side 30 opposite to the first main side 20.
- an n doped source layer 4,
- a p doped channel layer 5,
- an n- doped drift layer 6.

At least the source layer 4 is contacted o the first main side 20 by a first main electrode 2, which forms an ohmic contact 22 at least to the source layer 4. On the second main side 30, the drift layer 6 is contacted by a second main electrode 3, which forms a Schottky contact 32 to the drift layer 6. By having the main electrodes 2, 3 on opposite sides 20, 30 of the device, the device is a vertical device.

In the termination area 12 on the first main side 20 a p doped junction termination layer 8 is arranged.

On lateral sides 15 of the semiconductor device a bridging layer 9 is arranged, by which the junction termination layer 8 is connected to a potential of the second main electrode 3. The lateral sides 15 of the device are the sides between the first and second main side 20, 30 of the device.

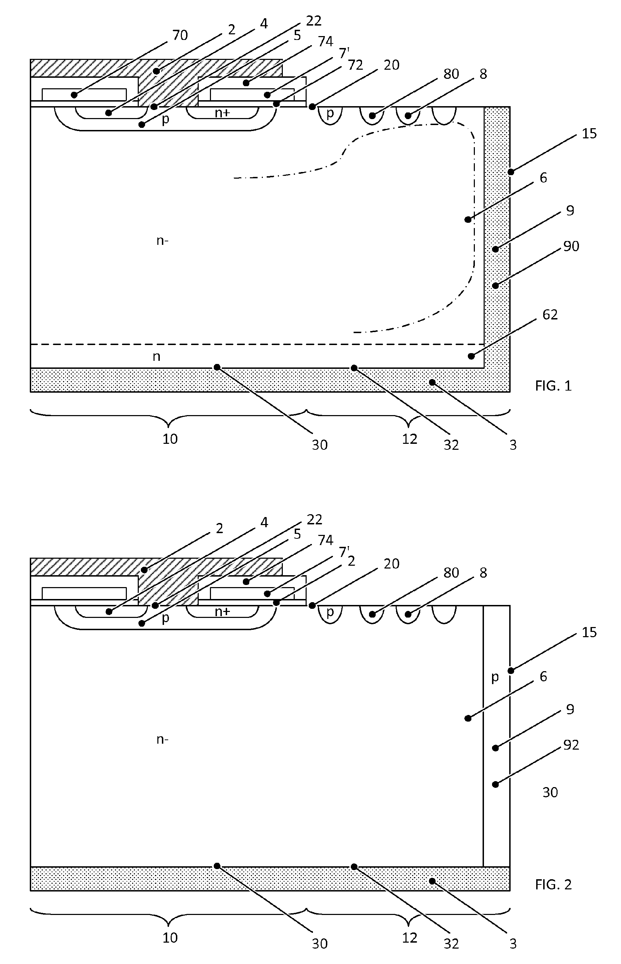

FIG 1 shows an inventive MOSFET 1. The device comprises the active area 10, in which a MOS cell is shown. The active area 10 extends through the semiconductor substrate from the first to the second main side 20, 30 and comprises areas, which are actively electrically controllable. In the active cell area 10 one or a plurality of cells are arranged. Each MOS cell comprises the source layer 4, the channel layer 5 and the drift layer 6. It is actively controlled by the first main electrode 2, which contacts as an ohmic contact 22 the source layer 4 and channel layer 5. For an inventive MOSFET 1, the first main electrode 2 forms a source electrode. On the second main side 30, the drift layer 6 contacts the second main electrode 3, which functions as a drain electrode, with a Schottky contact 32 to the drift layer 6. The invention only concerns such vertical devices, in which the main electrical contacts are arranged on opposite sides 20, 30.

The layers in the device (i.e. all doped layers in the active and termination area 10, 12) may be made of a wide bandgap material, exemplarily of silicon carbide, exemplarily of 3C-Silicon carbide or 4H-silicon carbide or 6H-silicon carbide, or of Gallium nitride or of Aluminum nitride. Alternatively, the layers may be made of Silicon.

The wide bandgap substrate may be made of any wide bandgap material like silicon carbide, Gallium nitride or Gallium arsenide, but any other wide bandgap material is also possible.

An ohmic contact 22 such as that at the first main electrode 2 is an electrical junction between two conductors (i.e. for a semiconductor between a metal layer and a semiconductor layer, e.g. a doped Silicon-carbide layer) which has a linear current-voltage behavior. An ohmic contact has low resistance. By contrast, a Schottky contact 32 such as that at the second main electrode 3 is a junction or contact that does not demonstrate a linear I-V curve (so that it is a non-ohmic contact). The Schottky barrier of a Schottky contact between a metal and a semiconductor band defines the device opening voltage in forward bias, i.e., carrier flows when the barrier is overcome.

In reverse blocking mode, the charge is deflected from the second main side 30 along the bridging layer 9 to the termination layer 8. Thereby, the lateral periphery of the device is brought into depletion.

The p doped junction termination layer 8 may be any p doped layer arranged in the termination area 12 and on the first main side 20, which is capable of reducing the electric field at the edge of the active area 10. At the edge of the device the electric field is terminated. The p doped junction termination layer 8 may have a maximum doping concentration in a range between 10¹⁷ to 10²⁰ cm⁻³ or 10¹⁸ to 10¹⁹ cm⁻³ or 2*10¹⁸ to 5*10¹⁸ cm⁻³. As shown in FIG 1, such termination layer 8 may be a field ring (or a plurality of field rings, i.e. at least two, which surround (enclose) the active area 10, wherein each field ring, which is arranged at a greater distance from the active area 10, encloses such field rings 80, which are arranged closer to the active area 10. The field rings 80 are separated from each other by an n doped layer, exemplarily by the drift layer 6.

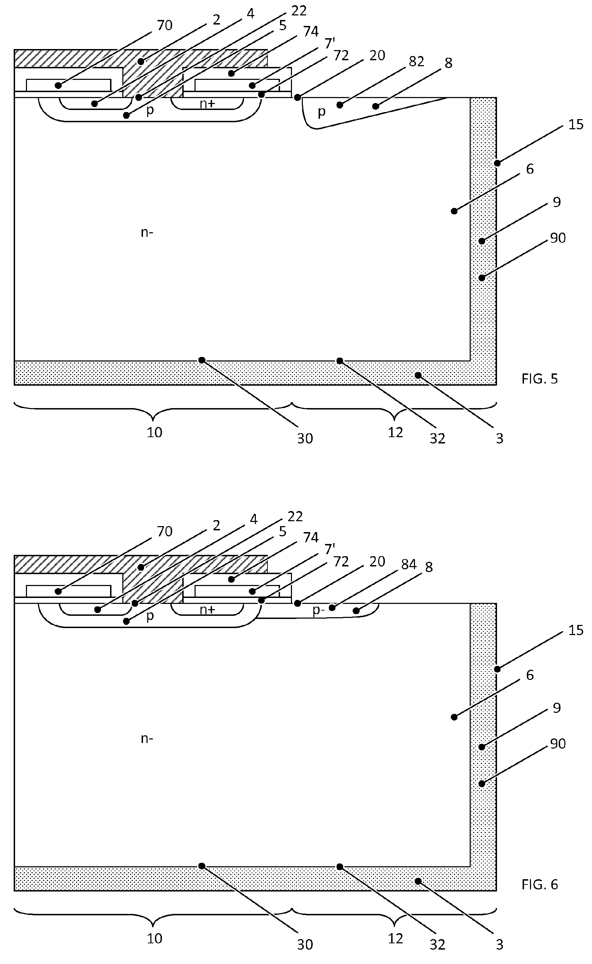

In another embodiment, as shown in FIG 5, the termination layer 8 is a variable lateral doping (VLD) layer 82, in which the doping concentration and/or depth of the VLD layer 82 decreases with larger distances from the active area 10. The doping concentration decreases laterally (i.e. in a plane parallel to the first main side 20) towards the lateral sides 15 of the device (notwithstanding local doping fluctuations which might occur due to the production method). The lateral decrease of doping concentration is available for all depths of the VLD layer 82. Exemplarily, the VLD layer 82 is a diffused layer, for which the doping concentration (doping profile, which shall be the doping concentration of the layer in depth direction, i.e. in a direction perpendicular to the first main side 20) decreases from a local maximum doping concentration continuously for greater depths from the first main side 20. Furthermore, the local maximum doping concentration of the VLD layer 82 (of such a doping profile) decreases with increasing distance, i.e. laterally, from the active cell area 10. Exemplarily also the thickness of the VLD layer 82 varies such that for increasing distance from the active cell area 10 the thickness decreases. Thus, the VLD layer 82 has local maximum doping concentrations, which shall be the maximum doping concentration of a doping profile at any place in the VLD layer 82, and an absolute maximum doping concentration, which shall be the maximum value of all doping concentrations in the VLD layer 82, i.e. also the maximum value of all local maximum doping concentrations.

In yet another inventive embodiment and as shown in FIG 6, the termination layer 8 is a junction termination extension (JTE) layer 84, which is a p doped layer which contacts the channel layer 5, but has a lower doping concentration than the channel layer 5. The JTE layer 84 is electrically connected to the first main electrode 2 only via the channel layer 5.

The termination layer 8 may also comprise trenches, which are filled with a p dopant. An insulating layer may separate such trenches from the other doped layers like the drift layer 6 or the trenches may contact the drift layer 6.

The termination layer 8 (80, 82, 84 or a combination thereof) may be covered by a field plate, which connects p doped regions of the termination layer 8 or by a passivation plate.

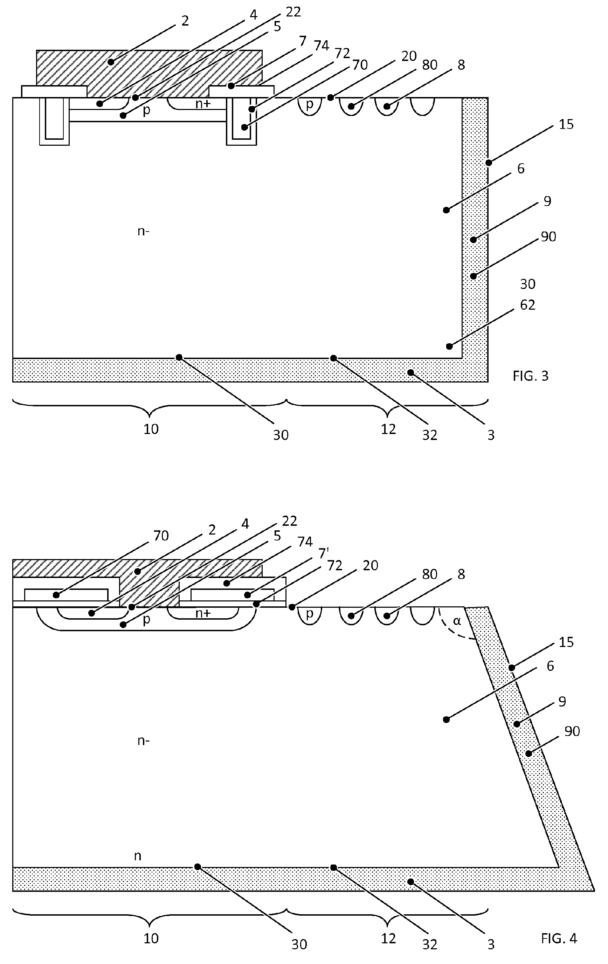

The inventive MOSFET 1 comprises between the first and the second main side 20, 30 lateral sides 15, by which the device is terminated. The lateral sides 15 of the device may be arranged vertically to the first main side 20 (or second main side 30) as shown in FIG 1. Alternatively, the lateral sides may form an angle α to the first main side 20, which is greater than 90° (FIG 4). Such an angle α may be helpful for the manufacturing method to implant the p dopant for the lateral termination layer 90 or to create the metal layer for the Schottky contact 90. In an exemplary embodiment, the angle α is between 70° to 110°.

On these lateral sides 15, a bridging layer 9 is arranged, which bridges, i.e. brings the electric potential from the second main side 30 to the termination layer 8 on the first main side 20. By such a bridging layer 9, the electric field is deflected from the second main side 30 along the lateral sides 15 to the termination layer 8.

In an exemplary embodiment, the bridging layer 9 is a lateral termination Schottky contact 90 (FIG 1). Thus, the second main electrode 3 formed as a Schottky contact 32 further extends over the lateral sides 15 of the device to bring the electric potential of the second main electrode 3 to the first main side 20, i.e. to the termination layer 8. The lateral termination Schottky contact 90 may be made from the same material as the Schottky contact 32 of the second main electrode 3. Both Schottky contacts 32, 90 may be formed together.

The bridging layer 9 may also be formed as a p doped lateral termination layer 92, which is connected to the second main electrode 3 (FIG 2). The lateral termination layer 92 extends along the lateral sides 15. The lateral termination layer 92 may be connected to the termination layer 8 on the first main side 20. In another alternative embodiment, the lateral termination layer 92 may be separated from the termination layer 8 by the drift layer 6. In such a case, the distance between the lateral termination layer 92 and the termination layer 8 is chosen to be so small that the electric field can be deflected from the lateral termination layer 92 to the termination layer 8 on the first main side 20 (the separation is also possible for the bridging layer 9 being formed as a lateral termination Schottky contact 90).

The p doped lateral termination layer 92 may have a maximum doping concentration in a range between 10¹⁷ to 10²⁰ cm⁻³ or 10¹⁸ to 10¹⁹ cm⁻³ or 2 * 10¹⁸ to 5 * 10¹⁸ cm⁻³. The maximum doping concentration of the lateral termination layer 92 may be the same as the maximum doping concentration of the junction termination layer 8. Both layers may be created simultaneously. The lateral termination layer 92 may be created by any appropriate manufacturing method like implanting a dopant on an inclined angle (angle α in FIG 4) or by etching a deep trench at least on the first main side 20, into which a dopant is implanted, and implanting a p dopant also from the second main side 30.

In an exemplary embodiment, the drift layer 6 comprises a uniformly and lowly doped drift region 60 on the first main side 20 and a higher doped contact region 62, which contacts the Schottky contact 32 of the second main electrode 3. Thus, the drift region 60 contacts the channel layer 5. The drift region 60 may have a doping concentration between 1 * 10¹⁴ to 5 * 10¹⁶ cm⁻³ and the contact region 62 may have a maximum doping concentration up to 1 * 10¹⁷ cm⁻³. The values for the doping concentration given above shall be understood as the mean doping concentration is case of constant doping concentration (not excluding variation of doping concentration due to imperfection of the manufacturing method) or as a maximum doping concentration in case of varying doping concentration. The contact region 62 is shown in FIG 1 by a dashed line, thereby indicating that such a layer 62 is optional. It acts as a drain layer for the inventive MOSFET 1. The doping concentration of such contact region 62 has to be chosen so low that a Schottky contact is formable at the interface of the contact region 62 and the second main electrode 3. Otherwise, at high doping concentrations such contacts may be converted to ohmic contacts. In another alternative embodiment, the whole drift layer 6 is uniformly and lowly doped (between 1 * 10¹⁴ to 5 * 10¹⁶ cm⁻³) so that such a device is a non-punch through device. Even for such an inventive non punch-through device, losses are much lower than for prior art devices, because the same drift layer can be used for blocking in both the forward and reverse mode.

The material of the second main electrode 3 is chosen such that a Schottky contact may be formed. Exemplarily, the material is a noble metal, i.e. a metal that is resistant to corrosion and oxidation in moist air. Noble metals are exemplarily Palladium, Platinum, Aluminium, or a compound comprising Titanium and at least one of Palladium, Platinum or Aluminium. In another exemplary embodiment, the material used for the creation of the first and/or second metal layer 5, 6 is a refractory metal, i.e. a metal that is extraordinarily resistant to heat and wear. Refractory metals are exemplarily Nickel, Titanium, Tantalum, Tungsten or Cobalt. The material used for the second main electrode 3 may also be a compound of any of the before mentioned metals.

In case of the inventive device being formed as an inventive MOSFET 1, the MOSFET comprises on the first main side 20 a gate electrode 7, 7'. Such gate electrode 7, 7' comprises an electrically conductive gate layer 70, which is insulated from any doped layer 4, 5, 6 in the active area 10 by a first insulating layer 72. Thus, the gate electrode 7, 7' is an insulated gate electrode, which may be formed as a trench gate electrode 7 (FIG 3) or a planar gate electrode 7' (FIG 1). The trench gate electrode 7 is arranged lateral to the channel and source layer 5, 4, which layers extend to the first insulating layer 72. On top of the gate layer 70, a second insulating layer 74 separates, i.e. insulates the gate layer 70 from the first main electrode 2.

For a planar gate electrode 7' as shown in FIG 1, the first insulating layer 72 is arranged on top of the channel, source and drift layer 5, 4, 6 and insulates the gate layer 70 from such doped layers 4, 5, 6. Again, a second insulating layer 74 separates the gate layer 70 from the first main electrode 2.

In case of the first insulating layer 72 being an oxide layer and the gate layer 70 being a metal, the inversion-channel is called a MOS channel (metal-oxide/insulator-semiconductor), whereas otherwise (insulating layers 72, 74 being made of any insulating materials; e.g. dielectrics such as high-k materials or Silicate glasses such as PSG or BPSG not excluding other insulators) the channel may also be called MIS channel (metal-insulator-semiconductor). As a material for the gate layer 70 any appropriate electrically conductive material like a metal or doped polycrystalline silicon may be used. The term MOS device/MOSFET shall also cover such MIS devices/ MISFETs.

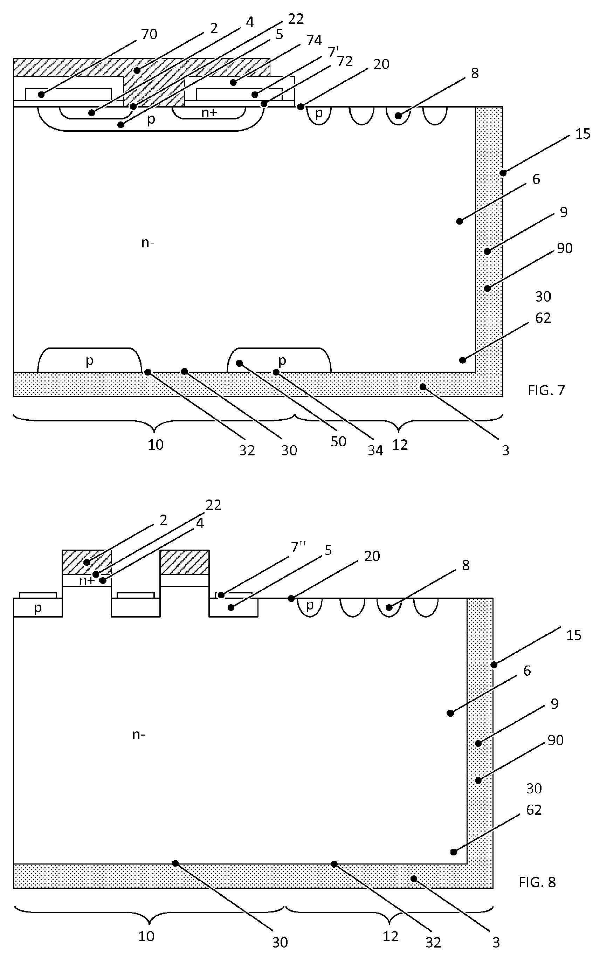

FIG 7 shows another inventive semiconductor device, which has an n doped layer on the second main side 30 (drift layer 6 or contact region 62), at which the second main electrode Schottky contact 32 is established, and alternatingly to the drift layer 6, a p doped anode layer 50, which forms an ohmic contact 34 to the second main electrode 3 such that an antiparallel diode is formed from the anode layer 50 to the source layer 4. The anode layer 50, which may comprise a single anode region or a plurality of anode regions separated from each other by the drift layer 6, provides IGBT functionality to the MOS device. The structure on the second main side 30 may also be called junction barrier Schottky (JBS) structure, which allows bipolar conduction in forward conduction mode under surge current conditions. The ohmic contact 34 at the second main electrode 3 can be easily created by applying a high doping concentration at the p anode layer 50 and performing a heat treatment, by which an ohmic contact 34 is established.

The JBS structure permits to extend the unipolar nature of the device to allow injection of holes from the p-doped regions as in a conventional JBS rectifier. The device with such a JBS structure acts as a hybrid MOSFET/IGBT with low conduction losses in the on-state and reverse blocking capability.

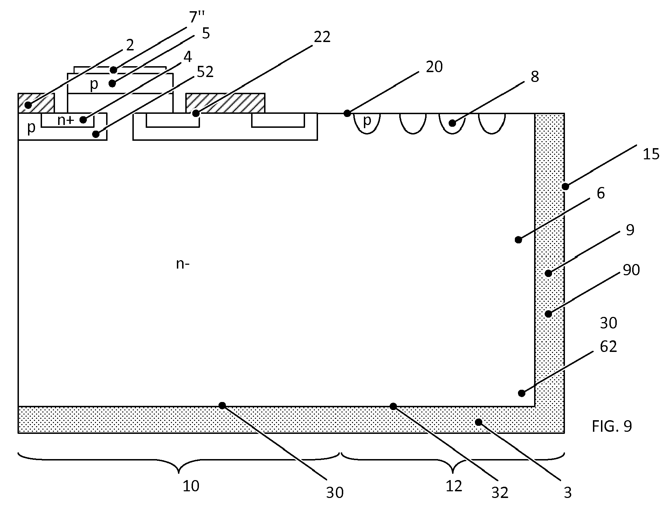

FIG 8 and 9 show inventive junction field effect transistors (JFETs). For such an inventive JFET 1', a gate layer 70 of a gate electrode 7" contacts the channel layer 5. FIG 8 shows a JFET called "normally off" JFET. The first main electrode 2 as an ohmic contact 22 only contacts the source layer 4. Channel layer 5 (contacting the gate electrode 7") and source layer 4 are separated from each other by the drift layer 6. FIG 9 shows another type of inventive JFET called "normally on" JFET, in which the source layer 4 is embedded in a p doped well layer 52 such that the source layer 4 is separated from the drift layer 6 by the well layer 52. In this case also the well layer 52 contacts the first main electrode 2.

In another embodiment, the conductivity types of the layers are switched, i.e. all layers of the first conductivity type are p type (e.g. drift layer 6) and all layers of the second conductivity type are n type (e.g. the channel layer 5).

### Reference List

- 1: MOSFET
- 1': JFET
- 10: active area
- 12: termination area
- 15: lateral side
- 2: first main electrode
- 20: first main side
- 22: ohmic contact
- 3: second main electrode
- 30: second main side
- 32: Schottky contact
- 34: ohmic contact to second main electrode
- 4: source layer
- 5: channel layer
- 50: anode layer
- 6: drift layer
- 60: drift region
- 62: contact region
- 7: trench gate electrode
- 7': planar gate electrode
- 7": JFET gate electrode
- 70, 70': gate layer
- 72: first insulating layer
- 74: second insulating layer
- 8: junction termination layer
- 80: field ring
- 82: variable lateral doping layer
- 84: junction termination extension layer
- 9: bridging layer
- 90: lateral termination Schottky contact
- 92: lateral termination layer

## Claims

1. A reverse blocking power semiconductor device, wherein in an active area (10), which is laterally surrounded by a termination area (12), following layers are arranged between a first main side (20) and a second main side (30) opposite to the first main side (20):
- a source layer (4) of a first conductivity type,
- a channel layer (5) of a second conductivity type, which is different from the first conductivity type,
- a drift layer (6) of the first conductivity type,
wherein in the termination area (12) on the first main side (20) a junction termination layer (8) of the second conductivity type is arranged,
wherein at least the source layer (4) is contacted by a first main electrode (2), which forms an ohmic contact (22) at least to the source layer (4), **characterized in, that**
the drift layer (6) is contacted on the second main side (30) by a second main electrode (3), which forms a Schottky contact (32) to the drift layer (6), and **in that**
on lateral sides (15) of the semiconductor device a bridging layer (9) is arranged, by which the junction termination layer (8) is connected to a potential of the second main electrode (3).

2. The device according to claim 1, **characterized in, that** the bridging layer (9) is a lateral termination Schottky contact (90).

3. The device according to claim 1, **characterized in, that** the bridging layer (9) is a lateral termination layer (92) of the second conductivity type.

4. The device according to claim 3, **characterized in, that** a maximum doping concentration of the junction termination layer (8) is the same as a maximum doping concentration of the lateral termination layer (92).

5. The device according to any of the claims 3 or 4, **characterized in, that** the lateral termination layer (92) has a maximum doping concentration in a range between 10¹⁷ to 10²⁰ cm⁻³ or 10¹⁸ to 10¹⁹ cm⁻³ or 2*10¹⁸ to 5*10¹⁸ cm⁻³.

6. The device according to any of the claims 1 to 5, **characterized in, that** the drift layer (6) comprises a uniformly and lowly doped drift region (60) on the first main side (20) and a higher doped contact region (62), which contacts the Schottky contact (32) of the second main electrode (3).

7. The device according to claim 6, **characterized in, that** the drift region (60) has a doping concentration between 1 * 10¹⁴ to 5 * 10¹⁶ cm⁻³.

8. The device according to any of the claims 6 or 7, **characterized in, that** the contact region (62) has a maximum doping concentration up to 1 * 10¹⁷ cm⁻³.

9. The device according to any of the claims 1 to 8, **characterized in, that** the device is a MOSFET (1), which has a gate electrode (7, 7') on the first main side (20), wherein the gate electrode (7, 7') comprises an electrically conductive gate layer (70), which is insulated from all layers (4, 5, 6) in the active area (10) by a first insulating layer (72).

10. The device according to any of the claims 1 to 8, **characterized in, that** the unipolar power semiconductor device is a JFET (1'), which has a gate electrode (7") on the first main side (20), wherein the gate electrode (7") comprises an electrically conductive gate layer (70'), which contacts the channel layer (5).

11. The device according to any of the claims 1 to 10, **characterized in, that** the device is a wide bandgap device or a silicon carbide or a Gallium nitride or a Aluminum nitride device.

12. The device according to any of the claims 1 to 11, **characterized in, that** the device comprises a trench gate electrode (7) or a planar gate electrode (7').

13. The device according to any of the claims 1 to 11, **characterized in, that** the lateral sides (15) of the device are arranged vertical to the first main side (20) or **in that** the lateral sides (15) of the device form an angle α to the first main side (20), which is greater than 90°.

14. The device according to any of the claims 1 to 13, **characterized in, that** on the second main side (30) an anode layer (50) of the second conductivity type is arranged, which forms an ohmic contact (34) to the second main electrode (3) such that an antiparallel diode is formed from the anode layer (50) to the source layer (4).

15. The device according to any of the claims 1 to 14, **characterized in, that** the junction termination layer (8) is at least one of
- at least one field ring (80),
- at least one variable lateral doping layer or
- a junction termination extension layer.
